**Europäisches Patentamt**

**European Patent Office**

**Office européen des brevets**

(11) Veröffentlichungsnummer: **0 061 513**
**B1**

(12) **EUROPÄISCHE PATENTSCHRIFT**

(45) Veröffentlichungstag der Patentschrift:
10.10.84

(51) Int. Cl.³: **H 03 K 17/693, G 11 C 7/00**

(21) Anmeldenummer: **81102461.1**

(22) Anmeldetag: **01.04.81**

(54) **Integrierte Auswahlschaltung in CMOS-Technik für vier Potentiale und deren Vereinfachung für drei Potentiale.**

(43) Veröffentlichungstag der Anmeldung:
06.10.82 Patentblatt 82/40

(45) Bekanntmachung des Hinweises auf die Patenterteilung:
10.10.84 Patentblatt 84/41

(84) Benannte Vertragsstaaten:
DE FR GB IT NL

(56) Entgegenhaltungen:
DE - B - 2 404 956
DE - B - 2 520 674
DE - B - 2 607 042
DE - B - 2 621 577
US - A - 3 936 676

(73) Patentinhaber: **Deutsche ITT Industries GmbH, Hans-Bunte-Strasse 19 Postfach 840, D-7800 Freiburg (DE)**

(84) Benannte Vertragsstaaten: **DE**

(73) Patentinhaber: **ITT INDUSTRIES INC., 320 Park Avenue, New York, NY 10022 (US)**

(84) Benannte Vertragsstaaten: **FR GB IT NL**

(72) Erfinder: **Adam, Fritz Günter Dr. rer. nat. Dipl.-Phys., Furtwänglerstrasse 10, D-7800 Freiburg (DE)**

(74) Vertreter: **Stutzer, Gerhard, Dr., Deutsche ITT Industries GmbH Patent- und Lizenzabteilung Hans-Bunte-Strasse 19 Postfach 840, D-7800 Freiburg (DE)**

BUNDESDRUCKEREI BERLIN

## Beschreibung

Die Erfindung bezieht sich auf eine integrierte Auswahlschaltung für vier Potentiale, nämlich das des Schaltungsnullpunktes U0 und drei davon verschiedene Potentiale U1, U2, U3, die in komplementärer Isolierschicht-Feldeffekttransistor-Technik, also der sogenannten CMOS-Technik, realisiert ist, gemäß dem Oberbegriff des Anspruchs 1. Eine derartige Schaltung ist aus der US-PS 3 936 676 bekannt.

Bei der Anwendung der CMOS-Technik tritt in bestimmten Fällen die Aufgabe auf, Potentiale möglichst niederohmig an bestimmte Schaltungsteile eines umfangreichen Schaltungssystems durchzuschalten. Ein solcher Anwendungsfall liegt beispielsweise beim Gegenstand der gleichzeitig eingereichten, veröffentlichten europäischen Anmeldung EP 61 512 A1 vor, wobei die durchzuschaltende Potentiale zum Programmieren der Transistoren mit nichtflüchtigem Speicherverhalten dienen sollen. Die Erfindung ist jedoch auf diesen Anwendungsfall nicht beschränkt, sondern kann immer dann angewendet werden, wenn eine CMOS-Schaltung zur Auswahl von maximal vier Potentialen erforderlich ist, deren vom Ausgang her gesehener Innenwiderstand möglichst niederohmig sein soll.

Die vorbekannte Anordnung besteht aus der Schaltstrecken-Serienschaltung zweier komplementärer Transistoren, deren Verbindungspunkt der Schaltungsausgang ist und welche Serienschaltung zwischen zweien der vier Potentiale liegt. Die beiden anderen Potentiale liegen über jeweils die Schaltstrecke von mindestens einem weiteren Transistor am Schaltungsausgang. Den Gates der Transistoren sind dabei Auswahlsignale für die einzelnen Potentiale zugeführt. Obwohl die bekannte Anordnung aus komplementären MOS-Transistoren aufgebaut ist, sind keine CMOS-Inverter verwendet, die bekanntlich dadurch realisiert sind, daß die Gates der beiden schaltstrecken-seriengeschalteten komplementären Transistoren miteinander verbunden sind und den Invertereingang bilden.

Die erwähnten Auswahlsignale werden bei der bekannten Anordnung aus einem zweistelligen Binärsignal mittels einer Logikschaltung gebildet, die aus vier UND-Gattern und drei Invertern besteht, wobei das eine UND-Gate und der ihm nachgeschaltete eine Inverter die Funktion eines NAND-Gates ergeben.

Die in den Ansprüchen gekennzeichnete Erfindung löst also die Aufgabe, eine in CMOS-Technik, also mit CMOS-Invertern, integrierte Auswahlschaltung für vier Potentiale anzugeben, deren vom Ausgang her gesehener Innenwiderstand möglichst niederohmig ist. Der Vorteil der erfindungsgemäßen Auswahlschaltung besteht darin, daß sie nur wenige Bauelemente, nämlich einen üblichen CMOS-Inverter und den beanspruchten modifizierten Inverter sowie einen Zusatztransistor umfaßt, so daß das Layout der integrierten Schaltung wenig Fläche beansprucht. Bei einer beanspruchten Vereinfachung der Erfindung kann sogar auf den Zusatztransistor und den den zweiten Inverter modifizierenden Zwischentransistor verzichtet werden, so daß die erfindungsgemäße Auswahlschaltun lediglich aus zwei in der beanspruchten Weise miteinander verkoppelten CMOS-Invertern besteht.

Für einen bestimmten Sonderfall der Erfindung, daß nämlich die vier Potentiale den vier Zuständen eines zweistelligen Binärsignals A, B zuzuordnen sind, sind in den Unteransprüchen besonders vorteilhafte Ausgestaltungen einer Eingangslogikschaltung als Weiterbildungen der erfindungsgemäßen Auswahlschaltung angegeben. Mittels dieser Weiterbildungen ist es also möglich, durch beliebige Zuordnung der vier Potentiale zu den vier Zuständen des zweistelligen Binärsignals A, B die konkrete Schaltung an den konkreten Bedarfsfall entsprechend anzupassen.

Die Erfindung wird nun anhand von in den Figuren der Zeichnung gezeigten Schaltbildern näher erläutert.

Fig. 1 zeigt die erfindungsgemäße Auswahlschaltung;

Fig. 2 zeigt die Zusammenschaltung der Auswahlschaltung nach Fig. 1 und der Eingangslogikschaltung nach Fig. 3;

Fig. 3 zeigt die zusammen mit der Auswahlschaltung nach Fig. 1 möglichen Ausbildungen der Eingangslogikschaltung, und zwar in

Fig. 3.1 bis 3.8 Eingangslogikschaltungen unter Verwendung eines NAND-Gatters und maximal drei Invertern und in

Fig. 3.9 bis 3.16 Eingangslogikschaltungen unter Verwendung eines NOR-Gatters mit maximal fünf Invertern,

Fig. 4 zeigt die bereits erwähnte, besonders günstige Vereinfachung der Auswahlschaltung nach Fig. 1 und

Fig. 5 zeigt reduzierte Eingangslogikschaltungen zur Vereinfachung nach Fig. 4.

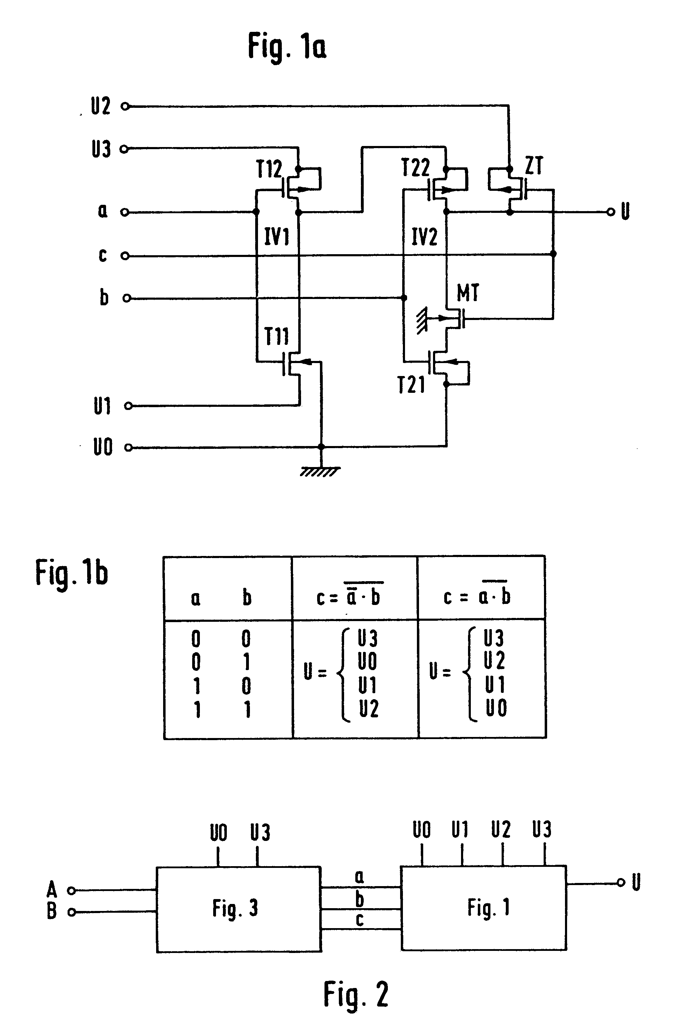

Das Schaltbild der erfindungsgemäßen Auswahlschaltung nach Fig. 1a zeigt den ersten Inverter IV1, dessen Schaltstrecke zwischen dem ersten Potential U1 und dem dritten Potential U3 liegt, wobei das Substrat des am Potential U1 liegenden Transistors T11 mit dem Schaltungsnullpunkt und somit mit dessen Potential U0 verbunden ist, das für die Zwecke der Beschreibung auch als viertes Potential bezeichnet werden kann. Das Substrat des anderen Transistors T12 des ersten Inverters IV1 ist mit dem dritten Potential U3 verbunden.

Der erste Inverter IV1 ist ein üblicher CMOS-Inverter, d.h., die Schaltstrecken seiner beiden Transistoren T11, T12 sind in Serie geschaltet, und die Gates dieser beiden Transistoren sind miteinander verbunden und bilden den Invertereingang, während der Verbindungspunkt der Schaltstrecken der beiden Transistoren T11, T12 den Inverterausgang bildet.

Das Schaltbild nach Fig. 1a zeigt ferner den zweiten Inverter IV2, der dadurch gegenüber einem üblichen CMOS-Inverter modifiziert ist, daß zwischen die Schaltstrecken der beiden Transistoren T21, T22 die Schaltstrecke des Zwischentransistors MT eingefügt ist. Der zweite Inverter liegt zwischen dem Schaltungsnullpunkt und somit dessen Potential U0 und dem Ausgang des ersten Inverters IV1. Das Substrat des Transistors T21 ist mit dem Schaltungsnullpunkt ebenso wie das des Zwischentransistors MT verbunden, während das Substrat des Transistors T22 eine eigene Isolierwanne für diesen Transistor bildet und mit dessen Source-Elektrode sowie mit dem Ausgang des ersten Inverters verbunden ist. Die Gates der Transistoren T21, T22 sind miteinander verbunden und bilden den Invertereingang, während der Verbindungspunkt der Schaltstrecken des Zwischentransistors MT und des Transistors T22 den Inverterausgang und auch den Ausgang der Auswahlschaltung bilden. Der Kanalleitungstyp des Zwischentransistors MT ist gleich dem des Transistors T22. Das zweite Potential U2 liegt über die Schaltstrecke des Zusatztransistors ZT, dessen Kanalleitungstyp gleich dem des Transistors T22 ist, am Ausgang der Auswahlschaltung. Der Zusatztransistor ZT hat als Substrat eine eigene Isolierwanne, die mit der Source-Elektrode dieses Transistors verbunden ist. Ein erstes und ein zweites Auswahlsignal a, b liegt am Eingang des ersten bzw. des zweiten Inverters IV1, IV2, während den Gates von Zwischen- und Zusatztransistor MT, ZT das dritte Auswahlsignal c zugeführt ist. Dieses und die beiden anderen Auswahlsignale a, b sind durch eine der beiden Booleschen Logikfunktionen

$$c = \overline{\overline{a} \cdot b} = a + \overline{b} \quad \text{oder} \quad c = \overline{\overline{a \cdot b}} = \overline{a} + \overline{b}$$

untereinander verknüpft. Die Fig. 1b zeigt für die beiden Logikfunktionen die entsprechende Zuordnung der Ausgangsspannung U der Auswahlschaltung zu den vier Potentialen U0 . . . U3. Die Tabelle der Fig. 1b gilt unter der weiteren Voraussetzung, daß die vier Potentiale der Beziehung

$$U,2 \, U3 > U1 > U0$$

genügen, wenn die Auswahlschaltung in CMOS-Technik mit n-Isolierwannen im p-Substrat eines Halbleiterkörpers realisiert wird, oder daß die Bedingung

$$U2, \, U3 < U1 < U0$$

erfüllt ist, wenn die Auswahlschaltung in CMOS-Technik mit p-Isolierwannen im n-Substrat des Halbleiterkörpers ausgeführt wird.

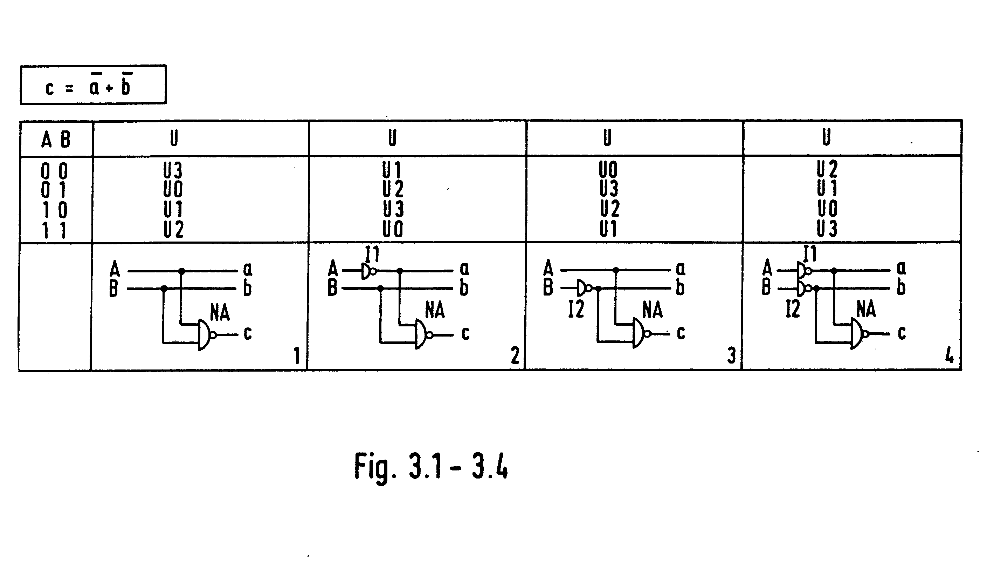

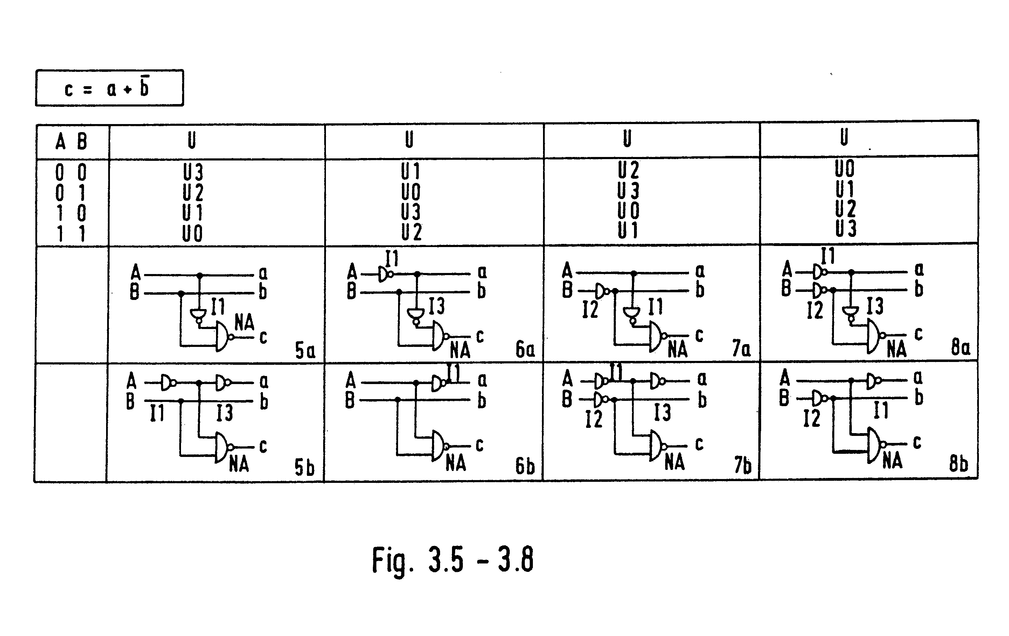

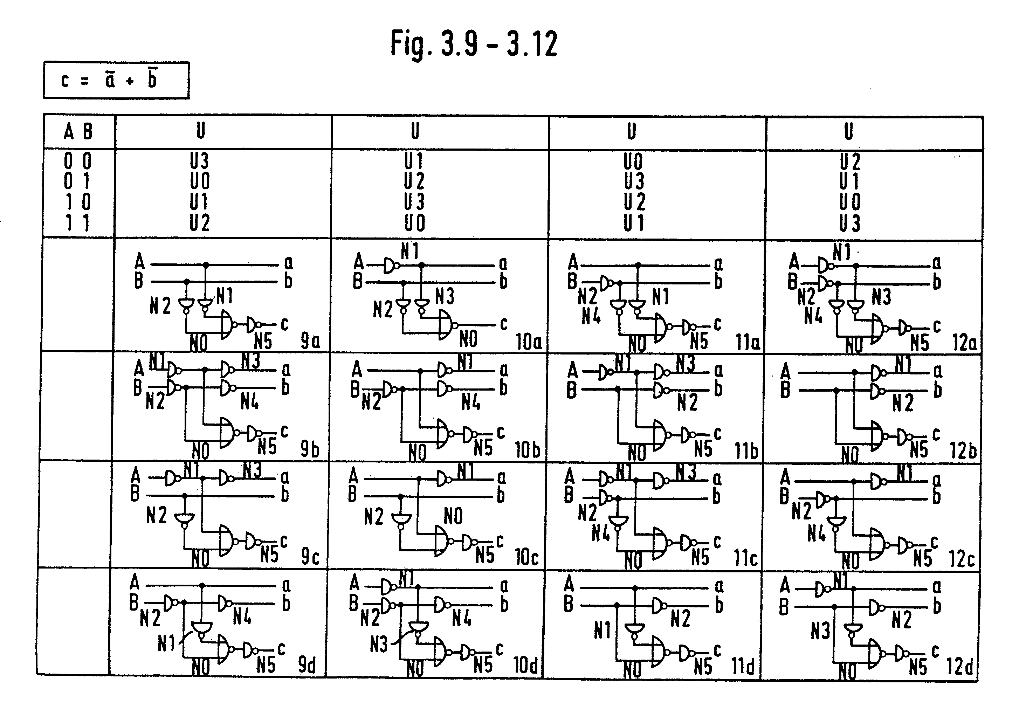

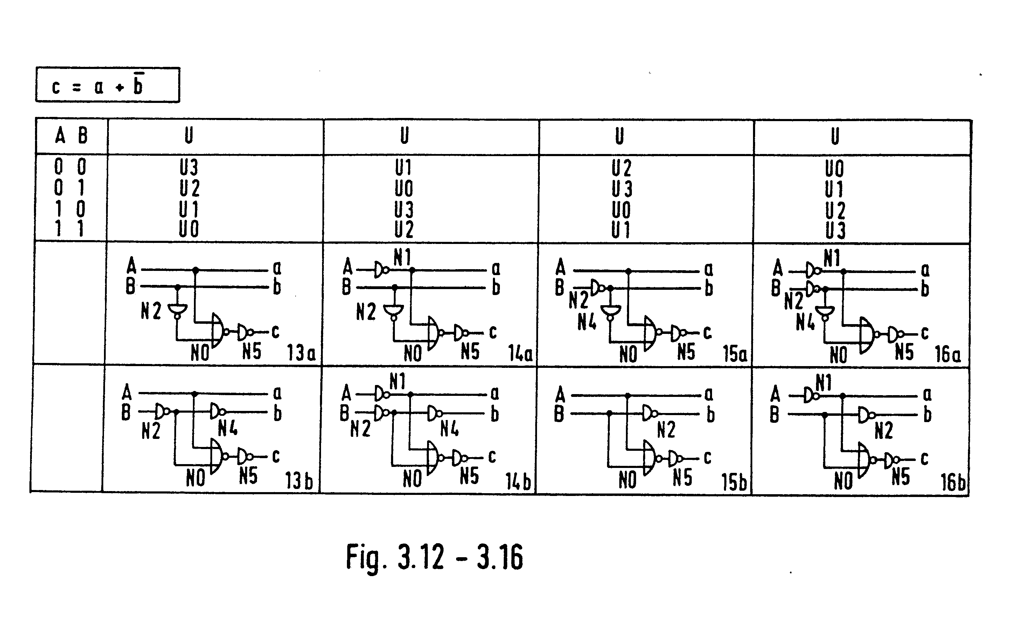

Nach einer vorteilhaften Weiterbildung der Erfindung kann die Auswahl der vier Potentiale U0 . . . U3 mittels der vier Zustände des zweistelligen Binärsignals A, B erfolgen, das der Eingangslogikschaltung zugeführt ist, wobei an deren erstem, zweitem bzw. drittem Ausgang das erste, zweite bzw. dritte Auswahlsignal a, b, c entsteht. Die Zusammenschaltung der Auswahlschaltung nach Fig. 1 und der Eingangslogikschaltung ist schematisch in Fig. 2 gezeigt, während die möglichen Varianten der Eingangslogikschaltung in den einzelnen Teilen der Fig. 3 gezeigt sind. Die Eingangslogikschaltung erhält als Betriebsspannung das dem Betrag nach niedrste und das dem Betrag nach höchste der vier Potentiale zugeführt; im Ausführungsbeispiel der Fig. 2 sind das die Potentiale U0 und U3.

Die Eingangslogikschaltung kann entweder mittels des NAND-Gatters NA und maximal drei Invertern I1, I2, I3 realisiert werden, wie dies die Fig. 3.1 bis 3.8 zeigen, oder mittels des NOR-Gatters NO und maximal fünf Invertern N1 . . . N5, wie dies die Fig. 3.9 bis 3.16 zeigen.

Die Fig. 3.1 bis 3.4 zeigen die NAND-Varianten der Logikfunktion $c = \overline{a} + \overline{b}$, während die Fig. 3.5 bis 3.8 die NAND-Varianten der Logikfunktion $c = a + \overline{b}$ zeigen. In vergleichbarer Weise zeigen die Fig. 3.9 bis 3.12 die NOR-Varianten für die Logikfunktion $c = \overline{a} + \overline{b}$ und die Fig. 3.13 bis 3.16 die NOR-Varianten der Logikfunktion $c = a + \overline{b}$.

In jeder der eben angesprochenen Figurengruppen sind die unter den oben genannten Bedingungen möglichen vier Möglichkeiten der Zuordnung der vier Potentiale U0 . . . U3 zu den vier Zuständen des zweistelligen Binärsignals AB tabellarisch gezeigt, wobei die jeweils möglichen Schaltungsvarianten angegeben sind. So zeigen die Fig. 3.1 bis 3.4 für jede der vier möglichen Zuordnungen eine Schaltung, die mit der entsprechenden Schaltungsnummer 1 . . . 4 bezeichnet ist. Die Fig. 3.5 bis 3,8 zeigen für jede der vier Möglichkeiten zwei Schaltungsvarianten, die mit den Ziffern 5a, 5b . . . 8a, 8b bezeichnet sind. Die Fig. 3.9 bis 3.12 zeigen für jede der vier Möglichkeiten vier Schaltungsvarianten, die mit den Ziffern 9a, 9b, 9c, 9d; 10a . . . 10d; 11a . . . 11d; 12a . . . 12d bezeichnet sind. Schließlich zeigen die Fig. 3.13 bis 3.16 für jede der vier Möglichkeiten wiederum zwei Schaltungsvarianten mit den Ziffern 13a, 13b . . . 16a, 16b.

In den einzelnen Teilen der Fig. 3 sind bei den NAND-Varianten die maximal drei Inverter mit I1, I2, I3 bezeichnet, wobei der eingangsseitig mit der ersten Binärsignalstelle A gespeiste Inverter mit I1, der eingangsseitig mit der zweiten Binärsignalstelle B gespeiste Inverter mit I2 und der eingangsseitig vom Ausgang des Inverters I1 gespeiste Inverter mit I3 bezeichnet ist. Für die Einzelschaltung der jeweiligen NAND-Varianten gilt ferner gemeinsam, daß das dritte Auswahlsignal c am Ausgang des NAND-Gatters NA entsteht. Für das erste und das zweite Auswahlsignal a, b ergibt sich die Verknüpfung mit den Binärsignalstellen A, B aus der jeweiligen Teilfigur der Fig. 3. Da diese Teilfiguren für sich selbst

3

sprechen, wird in der Beschreibung auf die einzelne Erläuterung dieser Figur verzichtet, zumal der Fachmann die Zusammenschaltung der jeweiligen NAND-Varianten ohne weiteres der Figur entnehmen kann.

Bei den NOR-Varianten nach den Fig. 3.9 bis 3.16 ist das NOR-Gatter mit NO bezeichnet, während den maximal fünf Invertern die Bezugzeichen N1 ... N5 zugewiesen sind. Der eingangsseitig mit der ersten Binärsignalstelle A gespeiste Inverter ist mit N1 und der eingangsseitig mit der zweiten Binärsignalstelle B gespeiste Inverter mit N2 bezeichnet. Der eingangsseitig mit dem Ausgang des ersten Inverters N1 verbundene Inverter ist mit N3 und der eingangsseitig mit dem Ausgang des Inverters N2 verbundene Inverter mit N4 bezeichnet, während der eingangsseitig mit dem Ausgang des NOR-Gatters NO verbundene Inverter das Bezugzeichen N5 trägt.

Die Zuordnung des ersten, zweiten und dritten Auswahlsignals a, b, c kann den einzelnen Teilfiguren der Fig. 3.9 bis 3.16 ohne weiteres entnommen werden, so daß auch hier auf die Einzelbeschreibung der Teilfiguren verzichtet werden kann, da der Fachmann diese ohne weiteres den Teilfiguren entnimmt.

Es ist hervorzuheben, daß in sämtlichen Teilfiguren der Fig. 3 nicht notwendigerweise die Gesamtzahl der möglichen Inverter kommt; so zeigt beispielsweise die Fig. 3.1 überhaupt keinen Inverter, während die maximal drei Inverter nur in den Fig. 3.7b und 3.8b auftreten. In ähnlicher Weise zeigen die Fig. 3.13a und 3.15b nur zwei Inverter und die Fig. 3.9b, 3.10d, 3.11c und 3.12a die maximale Inverterzahl von fünf.

Von besonderem Interesse sind diejenigen Varianten der Fig. 3, bei denen dem Nullzustand 00 des Binärsignals AB das dem Betrag nach niederste Potential U0, also das des Schaltungsnullpunktes, am Ausgang der Potentialauswahlschaltung zugeordnet ist, da dann bei einem Ausfall des Binärsignals ein Warte- oder Stand-by-Betrieb in der Nachfolgeschaltung hinter dem Ausgang der Potentialauswahlschaltung leicht zu realisieren ist. Die logische Null (z. B. A = 0) und die logische Eins (z. B. A = 1) sind dabei so definiert, daß das der Null zugeordnete Potential dem Substratpotential U0 der CMOS-Schaltung näher liegt als das der Eins zugeordnete Potential. Diese Schaltungsvarianten sind in den Fig. 3.3, 3.8, 3.11 und 3.16 gezeigt. Von den jeweils möglichen Varianten der Fig. 3.8, 3.11 und 3.16 sind, was den Schaltungsaufwand angeht, wiederum die Fig. 3.8b, 3.11d und 3.16b besonders günstig, da diese Schaltungsvarianten die jeweils geringste Inverteranzahl aufweisen. Die Eingangslogikschaltungen der Teilfiguren 3.3, 3.,8b, 3.11d und 3.16b sind somit die am meisten bevorzugten und in den Ansprüchen 5 bis 8 daher gekennzeichnet.

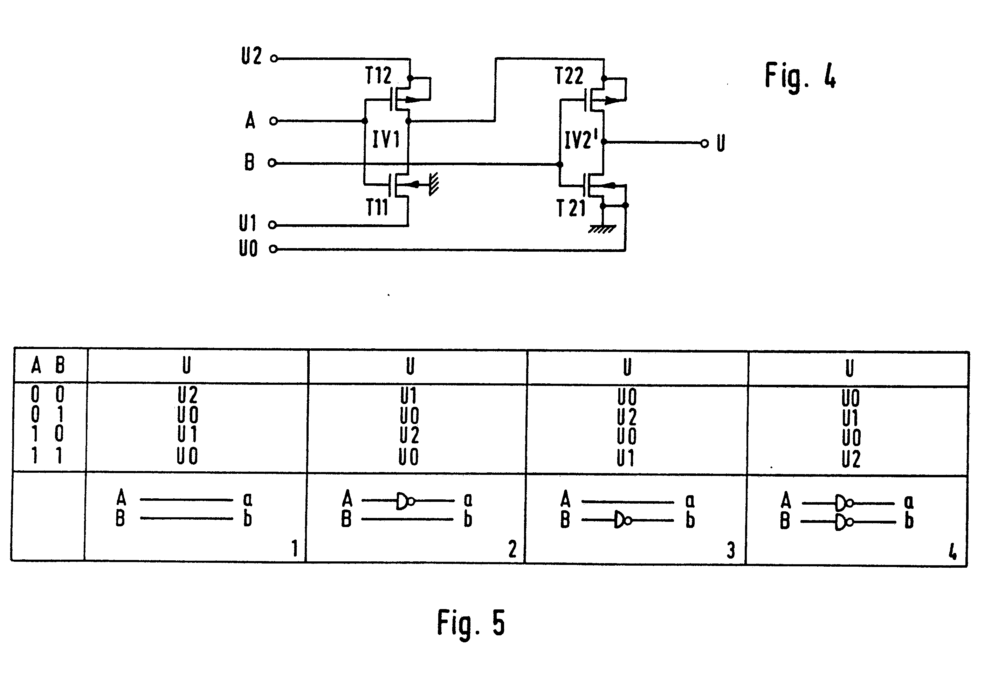

Die Fig. 4 zeigt eine im Rahmen der Erfindung liegende Vereinfachung der Auswahlschaltung nach Fig. 1, die dadurch zustandekommt, daß die beiden Potentiale U2, U3 identisch sind. Dann kann auf den Zwischentransistor MT und den Zusatztransistor ZT nach Fig. 1 verzichtet werden. Die möglichen Eingangslogikschaltungen reduzieren sich dann auf die vier in den Fig. 3.1 ... 3.4 gezeigten, jedoch unter Weglassen des NAND-Gates und des Auswahlsignals c. Fig. 5 zeigt die dann geltenden Wahrheitstabellen und Schaltungen. In Fig. 4 wird das zweistellige Binärsignal A, B dem Eingang des ersten Inverters IV1 bzw. dem des zweiten Inverters IV2' direkt zugeführt, vgl. Fig. 5.1; es sind somit lediglich die beiden Inverter IV1, IV2' vorhanden. Die den vier Zuständen des Binärsignals A, B zugeordneten Ausgangsspannungen U sind in der Tabelle der Fig. 5 angegeben. Wie daraus ersichtlich ist, ist zweien der vier Zustände, nämlich dem Nullzustand 00 und dem weiteren Zustand 10, das Potential U0 zugeordnet. Diese Eigenschaft, daß nämlich bei nur drei durchzuschaltenden Potentialen eines der Potentiale zwei Binärsignalzuständen zugeordnet ist, ergibt sich aus der Nichtübereinstimmung der Anzahl der Potentiale und der Anzahl der Binärsignalzustände.

Die Vereinfachung nach Fig. 4 stellt die einfachste Auswahlschaltung für drei Potentiale dar. Ausgehend von der Auswahlschaltung nach Fig. 1 gibt es aber auch Schaltungen, die mit Eingangslogikschaltungen zusammenzuschalten sind und die ebenfalls durch Verbindung der Anschlüsse für die Potentiale U2, U3 zu solchen gemacht werden können, mit denen drei Potentiale ausgewählt werden können.

## Patentansprüche

1. Integrierte Auswahlschaltung für vier Potentiale (das des Schaltungsnullpunktes U0 und drei davon verschiedene U1, U2, U3), die in komplementärer Isolierschicht-Feldeffekttransistor-Technik (CMOS-Technik) realisiert ist, wobei die Serienschaltung der Schaltstrecken zweier komplementärer Transistoren (T11, T12) zwischen dem ersten und dem dritten Potential (U1, U3) und das Substrat eines (T12) dieser Transistoren am dritten Potential (U3) liegt und dem Gate dieses Transistors (T12) ein erstes Auswahlsignal (a) zugeführt ist, gekennzeichnet durch folgende Merkmale:

— die Serienschaltung der beiden Transistoren (T11, T12) ist durch Verbindung ihrer Gates zu einem ersten Inverter (IV1) ergänzt,
— das Substrat des am ersten Potential (U1) liegenden Transistors (T11) ist mit dem Schaltungsnullpunkt (U0) verbunden,

— die Schaltstrecke eines derart modifizierten zweiten Inverters (IV2), daß zwischen die Schaltstrecken seiner beiden Transistoren (T21, T22) die Schaltstrecke eines Zwischentransistors (MT) vom gleichen Kanalleitungstyp wie der des am Schaltungsnullpunkt liegenden Transistors (T21) eingefügt ist, liegt zwischen dem Schaltungsnullpunkt und dem Ausgang des ersten Inverters (IV1), wobei das Substrat des am Schaltungsnullpunkt liegenden Transistors (T21) und das des Zwischentransistors (MT) mit dem Schaltungsnullpunkt verbunden ist und das Substrat des anderen Transistors (T22) eine eigene Isolierwanne für diesen Transistor bildet und mit dessen Source-Elektrode sowie mit dem Ausgang des ersten Inverters verbunden ist,

— der Verbindungspunkt der Schaltstrecken des Zwischentransistors (MT) und des anderen Transistors (T22) des zweiten Inverters (IV2) ist der Ausgang der Auswahlschaltung und liegt über die Schaltstrecke eines Zusatztransistors (ZT) vom gleichen Kanalleitungstyp wie der des anderen Transistors (T22) des zweiten Inverters (IV2) am zweiten Potential (U2)

— der Zusatztransistor (ZT) hat als Substrat eine eigene Isolierwanne, die mit der Source-Elektrode dieses Transistors verbunden ist,

— die vier Potentiale haben der Beziehung zu genügen:

$$U2, U3 > U1 > U0 ,$$

wenn die Auswahlschaltung in CMOS-Technik mit n-Isolierwannen in p-Substrat realisiert wird, oder

— sie haben der Beziehung zu genügen:

$$U2, U3 < U1 < U0 ,$$

wenn die Auswahlschaltung in CMOS-Technik mit p-Isolierwannen in n-Substrat ausgeführt wird,

— ein zweites Auswahlsignal (b) liegt am Eingang des zweiten Inverters (IV2) und ein drittes Auswahlsignal (c) an den Gates von Zwischen- und Zusatztransistor (MT, ZT), und

— für das dritte Auswahlsignal (c) gilt eine der Booleschen Logikfunktionen

$$c = \overline{\bar{a} \cdot \bar{b}} = a + b \quad \text{oder} \quad c = \overline{a \cdot b} = \bar{a} + \bar{b} .$$

2. Auswahlschaltung nach Anspruch 1, gekennzeichnet durch folgende Merkmale:

— die Auswahl der vier Potentiale (U0, U1, U2, U3) erfolgt mittels der vier Zustände eines zweistelligen Binärsignals (A, B), das einer Eingangslogikschaltung zugeführt ist, an deren erstem bzw. zweitem bzw. drittem Ausgang das erste bzw. zweite bzw. das dritte Auswahlsignal (a, b, c) entsteht.

3. Auswahlschaltung nach Anspruch 2, dadurch gekennzeichnet, daß die Eingangslogikschaltung entweder aus einem NAND-Gate (NA) und maximal drei Invertern (I1, I2, I3) oder aus einem NOR-Gate (NO) und maximal fünf Invertern aufgebaut ist, die von dem dem Betrag nach niedersten und dem Betrag nach höchsten der vier Potentiale (U0, U3) spannungsversorgt sind.

4. Auswahlschaltung nach den Ansprüchen 2 und 3, dadurch gekennzeichnet, daß dem Nullzustand (00) des zweistelligen Binärsignals (A, B) am Ausgang der Auswahlschaltung das Potential des Schaltungsnullpunktes (U0) zugeordnet ist.

5. Auswahlschaltung nach den Ansprüchen 3 und 4, gekennzeichnet durch folgende Merkmale (Fig. 3.3):

— die Eingangslogikschaltung verbindet die erste Binärsignalstelle (A) direkt mit dem ersten Ausgang, die zweite Binärstelle (B) jedoch unter Zwischenschaltung eines der Inverter (I2) mit dem zweiten Ausgang, und

— der dritte Ausgang ist der Ausgang des NAND-Gatters (NA), dessen beide Eingänge mit dem ersten bzw. zweiten Ausgang verbunden sind.

6. Auswahlschaltung nach den Ansprüchen 3 und 4, gekennzeichnet durch folgende Merkmale (Fig. 3.8b):

— die Eingangslogikschaltung verbindet die erste bzw. die zweite Binärsignalstelle (A, B) jeweils über einen der Inverter (I1, I2) mit dem ersten bzw. zweiten Ausgang, und

— der dritte Ausgang ist der Ausgang des NAND-Gatters (NA), dessen einem Eingang die erste Binärsignalstelle (A) zugeführt ist und dessen anderer Eingang mit dem zweiten Ausgang verbunden ist.

7. Auswahlschaltung nach den Ansprüchen 3 und 4, gekennzeichnet durch folgende Merkmale (Fig. 3.11d):

— die Eingangslogikschaltung verbindet die erste Binärsignalstelle (A) direkt mit dem ersten Ausgang und die zweite Binärsignalstelle (B) über einen der Inverter (N2) mit dem zweiten Ausgang, und
— der dritte Ausgang ist der Ausgang eines der anderen Inverter (N5), dessen Eingang am Ausgang des NOR-Gatters (NO) liegt, dessen einem Eingang die zweite Binärsignalstelle (B) zugeführt ist und dessen anderer Eingang mit dem Ausgang eines weiteren Inverters (N1) verbunden ist, dessen Eingang die erste Binärsignalstelle (A) zugeführt ist.

8. Auswahlschaltung nach den Ansprüchen 3 und 4, gekennzeichnet durch folgende Merkmale (Fig. 3.16b):

— die Eingangslogikschaltung verbindet die erste bzw. zweite Binärsignalstelle (A, B) jeweils über einen der Inverter (N1, N2) mit dem ersten bzw. dem zweiten Ausgang,
— der dritte Ausgang ist der Ausgang eines weiteren der Inverter (N5), dessen Eingang mit dem Ausgang des NOR-Gatters (NO) verbunden ist, und
— der erste Eingang des NOR-Gatters (NO) ist mit dem ersten Ausgang verbunden, während seinem zweiten Eingang die zweite Binärsignalstelle (B) zugeführt ist.

9. Vereinfachung der Auswahlschaltung nach einem der Ansprüche 1 bis 8 für die Auswahl von drei Potentialen (dem des Schaltungsnullpunktes U0 und zwei davon verschiedenen), dadurch gekennzeichnet, daß zwei Potentiale (U2, U3) identisch sind.

10. Vereinfachung der Auswahlschaltung nach Anspruch 9, dadurch gekennzeichnet, daß Zwischentransistor (MT) und Zusatztransistor (ZT) einschließlich seiner Potentialversorgung sowie das dritte Auswahlsignal (c) entfallen und die beiden Stellen des Binärsignals (A, B) die beiden verbleibenden Auswahlsignale (a, b) sind (Fig. 4, Fig. 5.1).

## Claims

1. Integrated selection circuit for four potentials (i.e. that of the zero point of the circuit [U0] and three potentials differing therefrom, i.e. U1, U2, U3), which is realized in a complementary insulated-gate field-effect transistor (CMOS-)technology, in which the series connection of the switching sections of the two complementary transistors (T11, T12) lies between the first and the third potential (U1), and the substrate of one of these transistors (T12) is connected to the third potential (U3), and a first selection signal (a) is fed to the gate of said transistor (T12), characterized by the following features:

— the series connection of the two transistors (T11, T12), owing to the connection of their gates, is completed to form a first inverter (IV1),
— the substrate of the transistor (T11) as connected to the first potential (U1), is connected to the zero point of the circuit (U0),
— the switching section of a second inverter (IV2) which is modified in such a way that between the switching sections of its two transistors (T21, T22) there is inserted the switching section of an intermediate transistor (MT) of the same channel conduction type as that of the transistor (T21) connected to the zero point of the circuit, is lying between the zero point of the circuit and the output of the first inverter (IV1), with the substrate of the transistor (T21) as connected to the zero point of the circuit, and the substrate of said intermediate transistor (MT) being connected to the zero point of the circuit, and with the substrate of the other transistor (T22) forming an insulating island of its own for this particular transistor and is connected to the source electrode thereof as well as to the output of said first inverter,
— the point connecting the switching sections of said intermediate transistor (MT) and of said other transistor (T22) of the second inverter (IV2) is the output of the selection circuit and, via the switching section of an additional transistor (ZT) of the same channel conduction type as that of said other transistor (T22) of said second inverter (IV2) is connected to the second potential (U2),
— the additional transistor (ZT), as a substrate, has an insulating island of its own which is connected to the source electrode of this transistor,
— the four potentials have to satisfy the relationship:

$$U2, U3 > U1 > U0 ,$$

when the selection circuit is realized in accordance with the known CMOS technology comprising n-insulating islands in a p-substrate, or
— they have to satisfy the relationship:

$$U2, U3 < U1 < U0 ,$$

when the selection circuit is realized in accordance with the known CMOS technology comprising p-insulating islands in a n-substrate,

**0 061 513**

— a second selection signal (b) is applied to the input of the second inverter (IV2), and a third selection signal (c) is applied to the gates of both said intermediate and said additional transistor (MT, ZT) and

— to said third selection signal (c) there applies one of the Boolean logic functions:

$$c = \overline{\overline{a} \cdot b} = a + \overline{b} \quad \text{or} \quad c = \overline{a \cdot b} = \overline{a} + \overline{b}.$$

2. A selection circuit as claimed in claim 1, characterized by the following features:

— the four potentials (U0, U1, U2, U3) are selected by means of the four states of a two-digit binary signal (A, B) which is applied to an input logic gate, at the first or second or third output of which there appears the first or second or third selection signal (a, b, c) respectively.

3. A selection circuit as claimed in claim 2, characterized in that said input logic gate is either composed of a NAND gate (NA) and a maximum of three inverters (I1, I2, I3) or else of a NOR gate (NO) and a maximum of five inverters, which are voltage-supplied by two of the four potentials (U0, U3) which, in terms of magnitude, are the lowest and the highest ones.

4. A selection circuit as claimed in claims 2 and 3, characterized in that, at the output of the selection circuit, the potential of the zero point of the circuit (U0) is assigned to the zero state (00) of the two-digit binary signal (A, B).

5. A selection circuit as claimed in claims 3 and 4, characterized by the following features (Fig. 3.3):

— the input logic gate connects the first binary signal digit (A) directly to the first output and connects the second binary signal digit (B), however, by the insertion of one of said inverters (I2) to the second output, and

— the third output is the output of the NAND gate (NA), with the two inputs thereof being connected to the first or the second output respectively.

6. A selection circuit as claimed in claims 3 and 4, characterized by the following features (Fig. 3.8b):

— the input logic gate connects the first or the second binary signal digit (A, B), each via an inverter (I1, I2) to the first of the second output respectively, and

— the third output is the output of the NAND gate (NA), to the one input of which the first binary signal digit (A) is applied, with the other input thereof being connected to the second output.

7. A selection circuit as claimed in claims 3 and 4, characterized by the following features (Fig. 3.11d):

— the input logic gate connects the first binary signal digit (A) directly to the first output and connects the second binary signal digit (B), via one of said inverters (N2) to the second output, and

— the third output is the output of one of said other inverters (N5) whose input is connected to the output of the NOR gate (NO), to the one input of which the second binary signal digit (B) is applied, with the other input thereof being connected to the output of a further inverter (N1) to the input of which the first binary signal digit (A) is applied.

8. A selection circuit as claimed in claims 3 and 4, characterized by the following features (Fig. 3.16b):

— the input logic gate connects the first or the second binary signal digit (A, B), each time via one of said inverters (N1, N2) to the first or the second output respectively,

— the third output is the output of a further one of said inverters (N5) whose input is connected to the output of said NOR gate (NO), and

— the first input of said NOR gate (NO) is connected to the first output, while the second binary signal digit (B) is applied to its second input.

9. A simplification of the selection circuit as claimed in any one of claims 1 to 8, for the selection of three potentials (that of the zero point of the circuit [U0] and two potentials differing therefrom), characterized in that two potentials (U2, U3) are identical.

10. A simplification of the selection circuit as claimed in claim 9, characterized in that said intermediate transistor (MT) and said additional transistor (ZT) including its potential supply, as well as the third selection signal (c) are omitted, and that the two digits of the binary signal (A, B) are the two remaining selection signals (a, b) (Fig. 5.1).


**Revendications**

1. Circuit de sélection intégré pour quatre potentiels (celui du point zéro du circuit, U0, et trois

7

potentiels, U1, U2, U3, différant de celui-ci) réalisé en technique à transistors à effet de champ complémentaires, à grille isolée (technique CMOS) dans lequel le circuit série des trajets de commutation de deux transistors complémentaires (T11, T12) se trouve entre le premier et le troisième potentiel (U1, U3) et le substrat de l'un (T12) de ces transistors est au troisième potentiel (U3), un premier signal de sélection (a) étant appliqué à la grille de ce transistor (T12), caractérisé en ce que:

— ledit circuit série des trajets de commutation de deux transistors complémentaires (T11, T12) est complété, par liaison de grilles de ces deux transistors (T11, T12) pour constituer un premier inverseur (IV1),

— le substrat du transistor (T11) se trouvant au premier potentiel (U1) est relié au point zéro (U0) du circuit,

— entre le point zéro du circuit et la sortie du premier inverseur (IV1), est inclus le trajet de commutation d'un deuxième inverseur (IV2) modifié de façon qu'entre les trajets de commutation de ses deux transistors (T21, T22) soit insérée le trajet de commutation d'un transistor intermédiaire (MT) dont le canal a le même type de conduction que celui du transistor (T21) connecté au point zéro du circuit, le substrat de ce transistor (T21) connecté au point zéro du circuit et le substrat du transistor intermédiaire (MT) étant reliés au point zéro du circuit, et le substrat de l'autre transistor (T22) constituant un volume d'isolement qui lui est propre et étant relié à l'électrode du source de celui-ci ainsi qu'à la sortie du premier inverseur,

— le point de jonction des trajets de commutation du transistor intermédiaire (MT) et de l'autre transistor (T22) du deuxième inverseur (IV2) est la sortie du circuit de sélection et est connecté, via le trajet de commutation d'un transistor supplémentaire (ZT) dont le canal a le même type de conduction que celui de l'autre transistor (T22) du deuxième inverseur (IV2), au deuxième potentiel (U2),

— le transistor supplémentaire (ZT) possède, en tant que substrat, son propre volume d'isolement qui est relié à l'électrode de source de ce transistor,

— les quatre potentiels doivent satisfaire à la relation:

$$U2, U3 > U1 > U0$$

si le circuit de sélection est réalisé en technique CMOS avec des volumes d'isolement n dans un substrat p, ou

— ils doivent satisfaire à la relation:

$$U2, U3 < U1 < U0$$

si le circuit de sélection est réalisé en technique CMOS avec volume d'isolement p dans un substrat n,

— un deuxième signal de sélection (b) est appliqué à l'entrée du deuxième inverseur (IV2), et un troisième signal de sélection (c) est appliqué à la grille du transistor intermédiaire (MT) et du transistor supplémentaire (ZT), et

— le troisième signal de sélection (c) satisfait à l'une des fonctions logiques booléennes suivantes:

$$c = \overline{\bar{a} \cdot b} = a + \bar{b} \text{ ou } c = \overline{a \cdot b} = \bar{a} + \bar{b}$$

2. Circuit de sélection selon la revendication 1, caractérisé en ce que:

— la sélection des quatre potentiels (U0, U1, U2, U3) s'effectue au moyen des quatre états d'un signal binaire à deux emplacements (A, B) appliqué à un circuit logique d'entrée ayant une première, une deuxième et une troisième sorties où apparaissent respectivement le premier, le deuxième et le troisième signal de sélection (a, b, c).

3. Circuit de sélection selon la revendication 2, caractérisé en ce que le circuit logique d'entrée est constitué soit d'une porte NAND (NA) et d'inverseurs, trois au maximum (I1, I2, I3), soit d'une porte NOR (NO) et d'inverseurs, cinq au maximum, qui sont alimentés en tension par celui des quatre potentiels (U0, U3) qui, en valeur, est le plus faible et par celui qui, en valeur, est le plus élevé.

4. Circuit de sélection selon les revendications 2 et 3, caractérisé en ce qu'à l'état zéro (00) du signal binaire à deux emplacements (A, B) correspond, à la sortie du circuit de sélection, le potentiel (U0) du point zéro du circuit.

5. Circuit de sélection selon les revendications 3 et 4, caractérisé en ce que (figure 3.3):

— le circuit logique d'entrée relie le premier emplacement de signal binaire (A) directement à la première sortie, mais relie toutefois, par l'intermédiaire d'un inverseur (I2), le deuxième emplacement de signal binaire (B) à la deuxième sortie, et

— la troisième sortie est la sortie de la porte NAND (NA) dont les deux entrées sont reliées respectivement à la première et à la deuxième sortie.

8

6. Circuit de sélection selon les revendications 3 et 4, caractérisé en ce que (figure 3.8b):

— le circuit logique d'entrée relie le premier et le deuxième emplacement de signal binaire (A, B) respectivement à la première et à la deuxième sortie, à chaque fois par l'intermédiaire d'un inverseur (I1, I2), et
— la troisième sortie est la sortie de la porte NAND (NA) dont la première entrée est connectée au premier emplacement de signal binaire (A) et dont l'autre entrée est reliée à la deuxième sortie.

7. Circuit de sélection selon les revendications 3 et 4, caractérisé en ce que (figure 3.11d):

— le circuit logique d'entrée relie le premier emplacement de signal binaire (A) directement à la première sortie, et relie, via l'un des inverseurs (N2), le deuxième emplacement de signal binaire (B) à la deuxième sortie et
— la troisième sortie est la sortie de l'un des autres inverseurs (N5) dont l'entrée est appliquée à la sortie de la porte NOR (NO) à la première entrée de laquelle est connecté le deuxième emplacement de signal binaire (B) et à l'autre entrée de laquelle est reliée la sortie d'un autre inverseur (N1) à l'entrée duquel est connecté le premier emplacement de signal binaire (A).

8. Circuit de sélection selon les revendications 3 et 4, caractérisé en ce que (figure 3.16b):

— le circuit logique d'entrée relie le premier et le deuxième emplacement de signal binaire (A, B) respectivement à la première et à la deuxième sortie, à chaque fois par l'intermédiaire de l'un des inverseurs (N1, N2),
— la troisième sortie d'un autre des inverseurs (N5) dont l'entrée est reliée à la sortie de la porte NOR (NO), et
— la première entrée de la porte NOR (NO) est reliée à la première sortie, tandis que le deuxième emplacement de signal binaire (B) est connecté à la deuxième entrée de cette porte NOR.

9. Simplification du circuit de sélection selon l'une des revendications 1 à 8, pour la sélection de trois potentiels (celui du point zéro, U0, du circuit et deux autres différant de celui-ci), caractérisé en ce que deux potentiels (U2, U3) sont identiques.

10. Simplification du circuit de sélection selon la revendication 1, caractérisé par l'absence de transistor intermédiaire (MT) et de transistor supplémentaire (ZT), alimentation en potentiel de celui-ci incluse, ainsi que par l'absence du troisième signal de sélection (c), et par le fait que les deux emplacements du signal binaire (A, B) donnent les signaux de sélection restants (a, b) (figure 4, figure 5.1).

9

# Fig. 1a

# Fig.1b

| a | b | $c = \overline{\overline{a} \cdot b}$ | $c = \overline{a \cdot b}$ |
|---|---|---|---|
| 0<br>0<br>1<br>1 | 0<br>1<br>0<br>1 | $U = \begin{cases} U3 \\ U0 \\ U1 \\ U2 \end{cases}$ | $U = \begin{cases} U3 \\ U2 \\ U1 \\ U0 \end{cases}$ |

# Fig. 2

$$c = \overline{a} + \overline{b}$$

| A B | U | U | U | U |
|-----|---|---|---|---|
| 0 0<br>0 1<br>1 0<br>1 1 | U3<br>U0<br>U1<br>U2 | U1<br>U2<br>U3<br>U0 | U0<br>U3<br>U2<br>U1 | U2<br>U1<br>U0<br>U3 |

Fig. 3.1 - 3.4

c = a + b̄

Fig. 3.5 - 3.8

# Fig. 3.9 - 3.12

$$c = \bar{a} + \bar{b}$$

| A B | U | U | U | U |
|---|---|---|---|---|
| 0 0 | U3 | U1 | U0 | U2 |
| 0 1 | U0 | U2 | U3 | U1 |
| 1 0 | U1 | U3 | U2 | U0 |
| 1 1 | U2 | U0 | U1 | U3 |

0 061 513

$$c = a + \bar{b}$$

| A B | U | U | U | U |
|---|---|---|---|---|
| 0 0<br>0 1<br>1 0<br>1 1 | U3<br>U2<br>U1<br>U0 | U1<br>U0<br>U3<br>U2 | U2<br>U3<br>U0<br>U1 | U0<br>U1<br>U2<br>U3 |
| | <br>13a | <br>14a | <br>15a | <br>16a |
| | <br>13b | <br>14b | <br>15b | <br>16b |

Fig. 3.12 - 3.16

0 061 513

Fig. 4

U2 — A — B — U1 — U0

T22   T12   IV1   IV2'   T21   T11   U

Fig. 5

| A B | | 1 | | 2 | | 3 | | 4 | |
|---|---|---|---|---|---|---|---|---|---|
| A | B | U | | U | | U | | U | |
| 0 | 0 | U2 | A — a | U1 | A — a | U0 | A — a | U0 | A — a |
| 1 | 0 | U0 | B — b | U0 | B — b | U2 | B — b | U1 | B — b |
| 0 | 1 | U1 | | U2 | | U0 | | U0 | |
| 1 | 1 | U0 | | U0 | | U1 | | U2 | |